# FASCICULE DE BREVET EUROPEEN

(11) **EP 3 868 187 B1**
(45) Date de publication et mention de la délivrance du brevet: **06.11.2024**
(21) Numéro de dépôt: 19782605.0
(22) Date de dépôt: 07.10.2019
(51) Int. Cl.: H05K 7/20

(54) **EQUIPEMENT ELECTRONIQUE POUR VEHICULE**
ELEKTRONISCHE VORRICHTUNG FÜR EIN FAHRZEUG
ELECTRONIC DEVICE FOR A VEHICLE

(30) Priorité: 17.10.2018 FR 1859604
(43) Date de publication de la demande: 25.08.2021
(73) Titulaire: Valeo Electrification, 95800 Cergy (FR)
(72) Inventeur: SMAL, Pierre, 95892 CERGY PONTOISE (FR); TALON, Emmanuel, 95892 CERGY PONTOISE (FR); FOUQUE, Aymeric, 95892 CERGY PONTOISE (FR)
(74) Mandataire: Valeo Powertrain Systems
(86) Numéro de dépôt international: PCT/EP2019/077046
(87) Numéro de publication internationale: WO 2020/078748

(56) Documents cités:
- EP-A1- 2 315 347
- EP-A2- 2 023 473
- JP-A- 2010 119 300

## Description

La présente invention concerne un équipement électronique pour véhicule. Cet équipement appartient par exemple au circuit électrique permettant l'alimentation électrique d'un moteur de propulsion d'un véhicule hybride ou électrique. Cet équipement réalise par exemple :
- la fonction d'unité de stockage d'énergie électrique,
- la fonction de commande de cette unité de stockage d'énergie électrique, et
- la fonction de convertisseur de tension continu/continu pour adapter le niveau de tension fourni par l'unité de stockage d'énergie électrique à des consommateurs du véhicule.

On connaît de la demande WO 2017/081255 un équipement électronique pour l'alimentation électrique d'un moteur de propulsion d'un véhicule, cet équipement comprenant un boîtier en deux parties, une partie de l'interface entre ces deux parties ayant une forme choisie pour que cette interface accueille une partie d'un canal de refroidissement parcouru par du fluide refroidissant tout ou partie de composants électroniques de l'équipement électronique. La réalisation de ce canal de refroidissement à l'interface entre les deux parties de boîtier est complexe car elle nécessite de ménager des formes spécifiques sur chacune de ces parties de boîtier au niveau de l'interface.

On connaît de la demande EP 2 023 473 un canal pour du fluide de refroidissement qui reste toujours dans un châssis, c'est-à-dire seulement dans une même partie de boîtier.

Il existe un besoin pour réaliser de façon simple un canal de refroidissement au sein d'un équipement électronique pour véhicule.

L'invention a pour objet de répondre à ce besoin et elle y parvient, selon l'un de ses aspects, à l'aide d'un équipement électronique pour véhicule automobile, comprenant :
- une première partie de boîtier apte à recevoir un ou plusieurs premiers composants électroniques,
- une deuxième partie de boîtier apte à recevoir un ou plusieurs deuxièmes composants électroniques, le deuxième boîtier étant assemblé avec le premier boîtier, et
- une entrée en fluide de refroidissement et une sortie en fluide de refroidissement,

un canal de refroidissement étant ménagé dans l'équipement électronique pour le fluide de refroidissement circulant de l'entrée en fluide vers la sortie en fluide, de manière à refroidir tout ou partie des premiers composants électroniques et/ou tout ou partie des deuxièmes composants électroniques,
ce canal ayant sur la majorité de son parcours dans l'équipement entre l'entrée et la sortie en fluide de refroidissement, notamment sur la totalité de son parcours dans l'équipement, une section perpendiculaire à la direction d'écoulement du fluide qui est : exclusivement ménagée dans la première partie de boîtier, ou exclusivement ménagée dans la deuxième partie de boîtier.

Dans l'équipement selon l'invention, on réduit, voire on supprime, les portions du canal de refroidissement dont la section perpendiculaire à la direction d'écoulement du fluide de refroidissement est délimitée à la fois par une ou plusieurs parois de la première partie de boîtier et par une ou plusieurs parois de la deuxième partie de boîtier. Autrement dit, On peut ainsi utiliser des première et deuxième partie de boîtier dont les surfaces en regard ont des formes plus simples. La fabrication d'une telle première partie de boîtier et d'une telle deuxième partie de boîtier est ainsi simplifiée.

Le canal peut, sur la totalité de son parcours dans l'équipement, présenter une section perpendiculaire à la direction d'écoulement du fluide qui est : exclusivement ménagée dans la première partie de boîtier, ou exclusivement ménagée dans la deuxième partie de boîtier, le cas échéant à l'exception des zones de passage de l'intérieur de la première partie de boîtier dans l'intérieur de la deuxième partie de boîtier et vice versa. Autrement dit, le canal comprend :
- une ou plusieurs portions dont la section perpendiculaire à la direction d'écoulement du fluide est exclusivement ménagée dans la première partie de boîtier,
- une ou plusieurs portions dont la section perpendiculaire à la direction d'écoulement du fluide est exclusivement ménagée dans la deuxième partie de boîtier,
- peu ou pas de portions dont la section perpendiculaire à la direction d'écoulement du fluide est ménagée dans la première partie de boîtier et dans la deuxième partie de boîtier.

Le canal présente par exemple sur plus de 80%, notamment plus de 90%, notamment plus de 95%, notamment plus de 97%, de son parcours dans l'équipement entre l'entrée et la sortie en fluide de refroidissement, une section perpendiculaire à la direction d'écoulement du fluide qui est : exclusivement ménagée dans la première partie de boîtier, ou exclusivement ménagée dans la deuxième partie de boîtier. Les pourcentages manquants pour arriver à 100% peuvent, le cas échéant, correspondre aux zones de passage de l'intérieur de la première partie de boîtier dans l'intérieur de la deuxième partie de boîtier et vice versa précitées.

Chacune de la première partie de boîtier et de la deuxième partie de boîtier peut présenter une paroi de fond et une paroi latérale s'étendant autour de la paroi de fond. La paroi de fond et la paroi latérale peuvent être réalisées d'une seule pièce, ou non. Lorsque chaque partie de boîtier est monobloc, cette partie de boîtier peut être réalisée en métal, par exemple via un coulage de métal sous pression tel que de l'aluminium.

Chaque paroi latérale peut s'étendre entre une extrémité de jonction avec la paroi de fond et une extrémité libre, et la première partie du boîtier et la deuxième partie de boîtier peuvent être assemblées par leur extrémité libre respective. Contrairement à l'art antérieur, ces extrémités libres formant alors l'interface entre la première partie de boîtier et la deuxième partie de boîtier peuvent avoir des formes simples. Un même plan peut définir l'extrémité libre de toute la paroi latérale de la première partie de boîtier et un autre plan parallèle peut définir l'extrémité libre de toute la paroi latérale de la deuxième partie de boîtier. Ces plans parallèles peuvent être amenés l'un contre l'autre lors de l'assemblage de la première partie de boîtier avec la deuxième partie de boîtier.

En variante, que l'extrémité libre de la paroi latérale de la première partie de boîtier et que l'extrémité libre de la paroi latérale de la deuxième partie de boîtier soient planes ou non, un joint d'étanchéité peut être interposé entre la première partie de boîtier et la deuxième partie de boîtier lorsque ces parties de boîtier sont assemblées.

Chacun desdits plans peut être sensiblement perpendiculaire à la paroi latérale dont il définit l'extrémité libre. En variante, les extrémités libres peuvent appartenir à des biseaux de forme complémentaire, plans ou non. Dans ce cas, la section du canal perpendiculaire à la direction de l'écoulement du fluide de refroidissement au niveau de ces biseaux peut être à la fois définie par la première partie de boîtier et par la deuxième partie de boîtier.

Le canal de refroidissement peut dans la première partie de boîtier, être ménagé uniquement dans la paroi latérale et dans la paroi de fond. Le canal de refroidissement peut, dans la deuxième partie de boîtier, être ménagé exclusivement dans la paroi latérale et dans la paroi de fond.

L'entrée et la sortie en fluide de refroidissement peuvent être montées sur la deuxième partie de boîtier. Cette entrée et cette sortie peuvent être montées sur une même face de la deuxième partie de boîtier, étant par exemple disposées côte à côte.

La deuxième partie de boîtier peut comprendre un corps sur lequel est rapportée une plaque, l'entrée et la sortie en fluide de refroidissement étant montées sur cette plaque et cette plaque définissant :
- la portion du canal de refroidissement immédiatement adjacente à l'entrée en fluide de refroidissement, et
- la portion du canal de refroidissement immédiatement adjacente à la sortie en fluide de refroidissement.

La plaque est par exemple réalisée par un coulage de métal sous pression tel que de l'aluminium.

La portion du canal de refroidissement immédiatement adjacente à l'entrée en fluide de refroidissement peut définir un embranchement entre deux branches pour le fluide entrant dans le canal de refroidissement et/ou la portion du canal de refroidissement immédiatement adjacente à la sortie en fluide de refroidissement peut définir une convergence entre deux branches vers la sortie du canal de refroidissement. En aval de l'embranchement, le fluide quittant la plaque peut directement gagner la première partie de boîtier. Le fluide peut alors circuler à travers la première partie de boîtier, avant de regagner la deuxième partie de boîtier.

La deuxième partie de boîtier peut comprendre une autre plaque rapportée sur le corps de la deuxième partie de boîtier. Cette autre plaque est par exemple réalisée par emboutissage, étant par exemple en aluminium. Cette autre plaque peut définir une portion du canal de refroidissement, notamment la portion du canal de refroidissement parcourue par le fluide de refroidissement dans la deuxième partie de boîtier, immédiatement après le parcours du fluide dans la première partie de boîtier.

La plaque et l'autre plaque peuvent appartenir à des faces opposées de la deuxième partie de boîtier. Dans ce cas, le parcours du fluide de refroidissement dans cette deuxième partie de boîtier peut s'effectuer exclusivement dans ces plaques et dans la paroi de fond.

La première partie de boîtier peut être monobloc ou ne pas être monobloc.

Dans tout ce qui précède, la paroi de fond de la première partie de boîtier et la paroi de fond de la deuxième partie de boîtier peuvent avoir des formes superposables et ces formes peuvent être un rectangle.

Dans tout ce qui précède, le fluide de refroidissement peut être un liquide, par exemple de l'eau glycolée.

Dans un exemple particulier, le canal comprend plusieurs branches, notamment deux branches, chacune de ces branches naissant à l'embranchement précité et terminant à la convergence précitée. Chacune de ces branches peut présenter sensiblement la même forme et une même section de passage peut être définie d'une branche à l'autre.

Dans un exemple particulier, le fluide de refroidissement peut circuler selon le parcours suivant dans l'équipement :
- parcours depuis l'entrée en fluide dans la plaque sur laquelle sont montées l'entrée et la sortie en fluide, un embranchement étant le cas échéant ménagé dans cette plaque,
- parcours dans la première partie de boîtier, le cas échéant successivement via une face de la paroi latérale de la première partie de boîtier puis via la paroi de fond de la première partie de boîtier puis via une autre face de la paroi latérale de la première partie de boîtier,
- parcours dans l'autre plaque de la deuxième partie de boîtier,
- parcours dans la paroi de fond de la deuxième partie de boîtier, puis
- parcours dans la plaque jusqu'à la sortie en fluide, une convergence étant le cas échéant ménagée dans cette plaque.

Chaque portion du canal ménagée dans une paroi de fond peut faire saillie par rapport au reste de cette paroi de fond, vers l'intérieur ou vers l'extérieur de l'équipement.

La première partie de boîtier reçoit par exemple des cellules formant une unité de stockage d'énergie électrique. L'unité de stockage d'énergie électrique a par exemple une tension nominale de 48 V. Quatorze cellules ou un nombre différent de cellules peuvent former cette unité de stockage d'énergie électrique, ces cellules étant notamment montées en série. Ces cellules de l'unité de stockage d'énergie électrique forment alors les premiers composants électroniques.

La deuxième partie de boîtier peut recevoir un convertisseur statique. Il s'agit par exemple d'un convertisseur de tension continu/continu, permettant de convertir un premier niveau de tension en un deuxième niveau de tension. Le premier niveau de tension est par exemple égal à 12 V et le deuxième niveau de tension est égal à 48 V, ou ce deuxième niveau de tension est égal à une tension supérieure, par exemple supérieure à 300 V. Dans ce cas, les deuxièmes composants électroniques peuvent comprendre des modules de puissance, des condensateurs et des inductances. La deuxième partie de boîtier peut, en combinaison avec la présence du convertisseur statique ou en l'absence de ce convertisseur, recevoir un système de gestion de l'unité de stockage d'énergie électrique (désigné en anglais par les initiales BMS qui signifient « battery management system »).

Dans tout ce qui précède, la première partie de boîtier et la deuxième partie de boîtier peuvent former le boîtier de l'équipement et encapsuler le ou les premiers composants électroniques, et/ou le ou les deuxièmes composants électroniques. En variante, certains des premiers composants électroniques sont disposés à l'intérieur du boîtier tandis que d'autres premiers composants électroniques sont portés par le boîtier mais disposés sur l'extérieur de ce boîtier et/ou certains des deuxièmes composants électroniques sont disposés à l'intérieur du boîtier tandis que d'autres deuxièmes composants électroniques sont portés par le boîtier mais disposés sur l'extérieur de ce boîtier.

Dans tout ce qui précède, et lorsque l'équipement électronique réalise la fonction de convertisseur de tension continu/continu, un connecteur électrique à deux niveaux de tension peut être présent, étant par exemple rapporté sur l'une des parties de boîtier, par exemple la première ou la deuxième partie de boîtier.

L'invention pourra être mieux comprise à la lecture qui va suivre d'un exemple non limitatif de mise en œuvre de celle-ci et à l'examen du dessin annexé sur lequel :
- la figure 1 représente une première partie de boîtier d'un équipement électronique selon un exemple de mise en œuvre de l'invention,
- la figure 2 représente une deuxième partie de boîtier destinée à être assemblée avec la première partie de boîtier de la figure 1,
- les figures 3 et 4 sont deux vues de dessus de la deuxième partie de boîtier, les deuxièmes composants électroniques ayant été omis sur cette figure,
- la figure 5 est une vue de côté de la deuxième partie de boîtier des figures 3 et 4, et
- la figure 6 est une vue similaire aux figures 3 et 4 de la deuxième partie de boîtier dans laquelle les deuxièmes composants électroniques sont représentés.

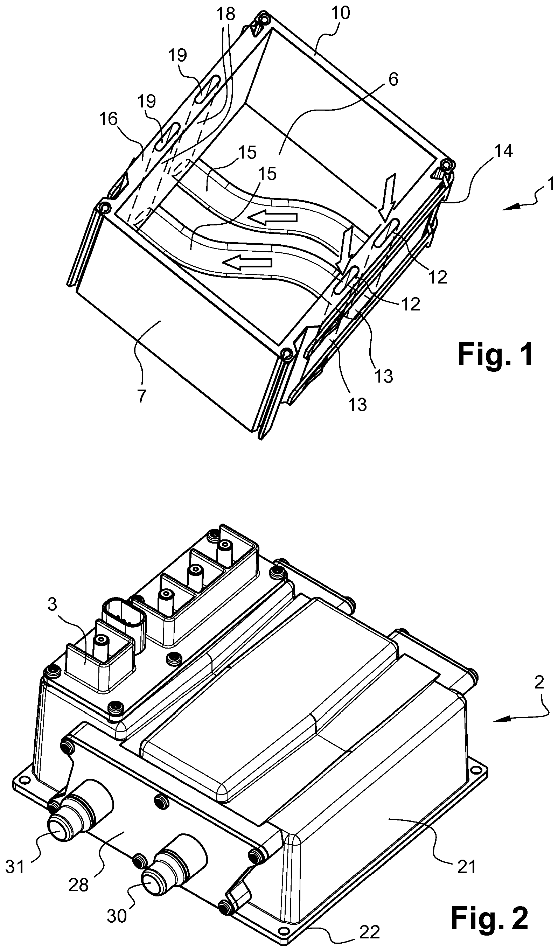

On a représenté sur la figure 1 un exemple de première partie de boîtier d'un équipement électronique selon l'invention. L'équipement électronique présente ici un boîtier formé par l'assemblage de la première partie de boîtier 1 avec une deuxième partie de boîtier 2 qui sera décrite en référence aux figures 2 à 6. Un joint d'étanchéité peut, le cas échéant, être interposé entre la première partie de boîtier 1 et la deuxième partie de boîtier 2 lorsque ces parties de boîtier sont assemblées entre elles.

Cet équipement fait dans l'exemple décrit partie du circuit électrique permettant d'alimenter électriquement le moteur électrique de propulsion d'un véhicule hybride ou électrique. L'équipement regroupe dans l'exemple décrit les blocs fonctionnels suivants : unité de stockage d'énergie électrique, convertisseur de tension continu/continu, et système de gestion de l'unité de stockage d'énergie électrique (encore appelé « BMS » en anglais). Comme on le verra sur la figure 2, l'équipement comprend dans l'exemple considéré un connecteur électrique 3 comprenant des contacts permettant la connexion à un réseau électrique d'un premier niveau de tension et d'autres contacts permettant la connexion à un réseau électrique d'un deuxième niveau de tension.

Dans l'exemple considéré, le premier niveau de tension est par exemple 12 V et le réseau ayant ce niveau de tension peut comprendre une unité de stockage d'énergie électrique à cette tension et former le réseau de bord classique du véhicule. Toujours dans l'exemple considéré, le deuxième niveau de tension est de 48 V, et le réseau ayant ce niveau de tension permet l'alimentation électrique du moteur électrique de propulsion du véhicule. D'autres valeurs de tension sont cependant possibles pour le premier niveau de tension et/ou pour le deuxième niveau de tension. Le deuxième niveau de tension peut par exemple en variante avoir une valeur supérieure à 300 V.

La première partie de boîtier 1 reçoit dans l'exemple considéré des cellules formant l'unité de stockage d'énergie électrique. Quatorze cellules sont par exemple connectées en série de manière à fournir une tension nominale de 48 V. Ces cellules, correspondant à des premiers composants électroniques disposés dans la première partie de boîtier 1, ne sont pas représentées sur la figure 1.

On constate sur la figure 1 que la première partie de boîtier 1 comprend une paroi de fond 6 de forme sensiblement rectangulaire et une paroi latérale 7. Dans l'exemple considéré, la paroi de fond 6 est réalisée par coulage sous pression tandis que la paroi latérale 7 est réalisée par extrusion. Dans une variante, ces parois 6 et 7 pourraient être réalisées de façon monobloc.

La paroi latérale 7 s'étend dans l'exemple considéré tout autour de la paroi de fond 6, entre une extrémité de jonction avec la paroi de fond 6 et une extrémité libre 10. On constate sur la figure 1 que l'extrémité libre 10 peut appartenir à un même plan dans sa totalité, et ce plan est ici sensiblement parallèle à la paroi de fond 6.

Comme on le verra par la suite, un canal de refroidissement est ménagé dans la première partie de boîtier 1, se présentant dans cette première partie de boîtier 1 sous la forme de deux branches disposées côté à côté. Chaque branche comprend ici une portion 13 ménagée dans une face 14 de la paroi latérale 7, entre un orifice respectif 12 ménagé dans cette extrémité libre 10 et la paroi de fond 6. Chaque portion 13 est prolongée par une portion 15 ménagée dans la paroi de fond 6, chaque portion 15 pouvant ou non faire saillie vers l'intérieur de l'équipement par rapport au reste de cette paroi de fond 6. Dans l'exemple considéré, les deux portions 15 ont chacune une forme ondulée dans la paroi de fond 6 entre la face 14 de la paroi latérale 7 et une autre face 16 de cette paroi latérale, opposée à la face 14. Chaque portion 15 d'une branche est prolongée dans la face 16 de la paroi latérale 7 par une portion 18 ménagée au sein de cette face 16, et chaque portion 18 s'étend de manière sensiblement rectiligne entre la paroi de fond 6 et un orifice respectif 19 ménagé dans l'extrémité libre 10.

On va maintenant décrire en référence aux figures 2 à 6 une deuxième partie de boîtier 2 selon l'exemple de mise en œuvre considéré.

Comme on peut le voir sur les figures, la deuxième partie de boîtier 2 comprend, similairement à la première partie de boîtier 1, une paroi de fond 20 et une paroi latérale 21 s'étendant tout autour de la paroi de fond 20. La paroi de fond 20 a également une forme sensiblement rectangulaire.

La paroi latérale 21 s'étend entre une extrémité de jonction avec la paroi de fond 20 et une extrémité libre 22. Cette extrémité libre 22 s'étend ici entièrement dans un plan et, dans l'exemple considéré, ce plan est parallèle au plan dans lequel s'étend l'extrémité libre 10 de la première partie de boîtier 1.

La deuxième partie de boîtier 2 est ici formée d'un corps qui définit dans l'exemple considéré la paroi de fond 20 et une partie de la paroi latérale 21. Ce corps est ici réalisé par coulage sous pression d'aluminium. Sur ce corps est rapporté le connecteur électrique 3 mentionné précédemment. Ce connecteur électrique 3 est ici monté sur la paroi de fond 20, sur l'extérieur de celle-ci.

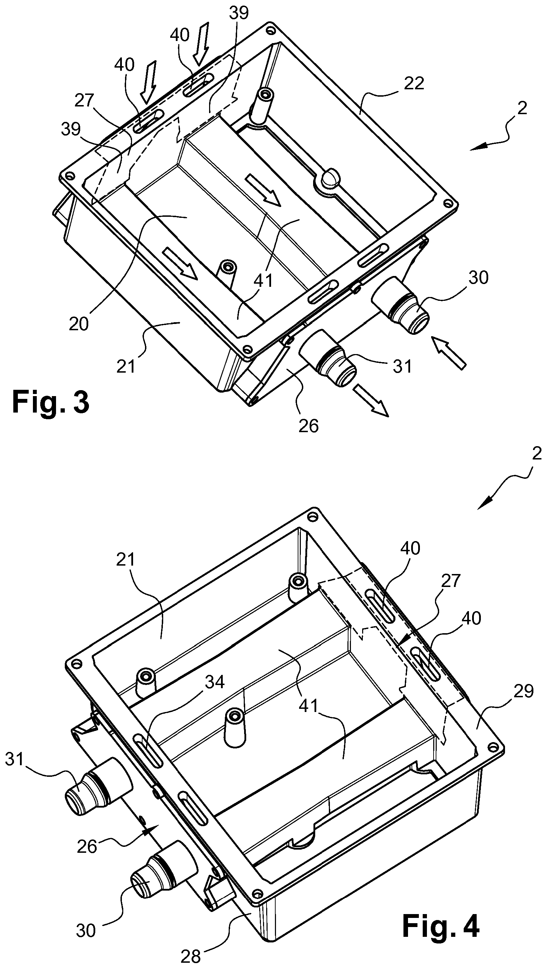

On constate également sur les figures 3 et 4 que deux plaques 26 et 27 sont rapportées sur le corps, respectivement sur deux faces 28 et 29 de la paroi latérale 21. La plaque 26 est par exemple réalisée par coulage sous pression d'aluminium tandis que la plaque 27 est réalisée par emboutissage d'aluminium. On constate encore sur les figures 2 à 4 qu'une entrée en fluide de refroidissement 30 ainsi qu'une sortie en fluide de refroidissement 31 sont fixées sur la plaque 26. Cette entrée 30 et cette sortie 31 sont ici formées par des embouts droits qui sont disposés côte à côte. En variante, les embouts utilisés pourraient être courbes.

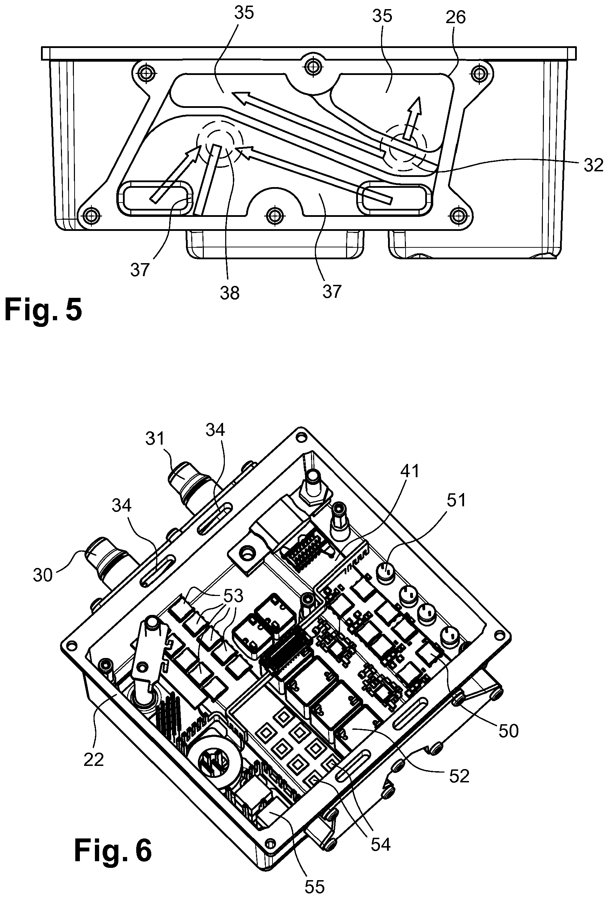

Comme on peut le voir sur la figure 5, l'entrée en fluide de refroidissement 30 débouche dans la plaque 26 via un orifice 32 et la plaque 26 définit, pour le fluide pénétrant par cet orifice 32, un embranchement par lequel le canal de refroidissement se sépare en deux branches. Chacune de ces branches est alors définie par une portion 35 s'étendant dans la plaque 26 de l'embranchement jusqu'à un orifice 34 respectif ménagé dans l'extrémité libre 22 de la paroi latérale 21 de la deuxième partie de boîtier 2.

On constate encore sur la figure 5 que la plaque 26 définit également une convergence pour les deux branches du canal de refroidissement. Chaque branche comprend une portion terminale 37 dans la plaque 26, et cette portion terminale 37 s'étend dans la plaque 26 jusqu'à la convergence. La plaque 26 comprend encore un orifice 38 connecté à la sortie en fluide de refroidissement 31 permettant au fluide de refroidissement de quitter la plaque 26 vers la sortie 31.

On constate sur les figures 3 et 4 que la plaque 27 définit pour chaque branche du canal de refroidissement une portion 39, chaque portion 39 s'étendant entre un orifice respectif 40 par lequel le fluide de refroidissement gagne la deuxième partie de boîtier 2 depuis la première partie de boîtier 1 et la paroi de fond 20. On constate ici que d'une branche à l'autre, les portions 39 ont une même forme rectiligne mais divergent l'une par rapport à l'autre.

Chaque portion 39 est prolongée par une portion 41 qui est ménagée dans la paroi de fond 20 et qui est rectiligne. Les deux portions 41 sont ici parallèles. Chaque portion 41 s'étend jusqu'à la plaque 26, où elle est prolongée par une portion terminale 37. Chaque portion 41 fait dans l'exemple considéré saillie vers l'intérieur de l'équipement par rapport au reste de la paroi de fond 20.

Le parcours du fluide de refroidissement, qui est par exemple de l'eau glycolée, dans l'équipement, va être décrit en référence aux figures 1, 3 et 5 sur lesquelles des flèches ont été représentées.

Le fluide de refroidissement gagnant l'équipement par l'entrée en fluide de refroidissement 30 débouche dans la plaque 26 via l'orifice 32. Le fluide de refroidissement se répartit alors entre deux branches via les portions 35 et quitte la deuxième partie de boîtier via un orifice 34 respectif ménagé dans l'extrémité libre 22 de la paroi périphérique 21 de cette deuxième partie de boîtier 2. Ce fluide de refroidissement gagne alors la première partie de boîtier via un orifice 12 respectif ménagé dans l'extrémité libre 10 de la paroi périphérique 7 et circule ensuite successivement dans les portions 13, 15 et 18 décrites précédemment jusqu'à un orifice respectif 19 ménagé dans l'extrémité libre 10 de la paroi latérale 7 de la première partie de boîtier 1. Quittant cette première partie de boîtier 1 via cet orifice 19, le fluide de refroidissement retourne alors dans la deuxième partie de boîtier 2 via un orifice 40 dans la plaque 27 puis emprunte successivement les portions 39, 41 et 37 décrites ci-dessus. Les deux branches se rejoignent dans la plaque 26 au niveau de la convergence, puis le fluide de refroidissement quitte la deuxième partie de boîtier 2 via l'orifice 38 par lequel il atteint la sortie en fluide de refroidissement 31.

Dans l'exemple considéré, en tout point du canal de refroidissement, sa section perpendiculaire à la direction de l'écoulement est exclusivement ménagée dans la première partie de boîtier 1 ou exclusivement ménagée dans la deuxième partie de boîtier 2. Selon que l'extrémité libre 11 de la paroi latérale 7 de la première partie de boîtier 1 et que l'extrémité libre 22 de la paroi latérale 21 de la deuxième partie de boîtier 2 appartiennent ou non respectivement à des plans parallèles entre eux et perpendiculaire à leur paroi latérale respective, des sections du canal de refroidissement perpendiculaires à la direction de l'écoulement qui seraient ménagée à la fois dans la première partie de boîtier 1 et dans la deuxième partie de boîtier 2 peuvent exister au niveau de l'interface entre ces deux parties de boîtier.

Sur les figures 2 à 5, les deuxièmes composants électroniques reçus dans la deuxième partie de boîtier 2 et qui permettent dans l'exemple décrit d'assurer les fonctions de convertisseur de tension continu/continu et de gestion des cellules de l'unité de stockage d'énergie électrique n'ont pas été représentés.

Sur la figure 6, ces composants sont visibles. On constate ainsi que, sont ici disposés sur la paroi de fond 21 de la deuxième partie de boîtier 2 :
- des modules de puissance 50, des condensateurs 51, et des inductances 52 formant le convertisseur de tension continu/continu,
- des unités 53 formant le système de gestion des cellules de l'unité de stockage d'énergie électrique de la première partie de boîtier 1,
- des interrupteurs électroniques commandables 54, par exemple des transistors MOS, prévus en cas de défaillance (« safety » en anglais),
- un filtre des interférences électromagnétiques 55 pour le niveau de tension 12 V.

L'invention n'est pas limitée à l'exemple qui vient d'être décrit.

En particulier, bien que l'invention ait été décrite avec des premiers et deuxièmes composants électroniques qui sont disposés à l'intérieur de chaque partie de boîtier 1, 2 de manière à ce que ces composants soient encapsulés par le boîtier formé par l'assemblage des parties de boîtier 1 et 2, l'invention peut être autre. Tout ou partie des premiers composants électroniques et/ou tout ou partie des deuxièmes composants électroniques peut par exemple être porté par une paroi de fond de la partie de boîtier correspondante, en étant disposé à l'extérieur de cette paroi de fond.

## Revendications

1. Equipement électronique pour véhicule automobile, comprenant :
- une première partie de boîtier (1) apte à recevoir un ou plusieurs premiers composants électroniques,
- une deuxième partie de boîtier (2) apte à recevoir un ou plusieurs deuxièmes composants électroniques (50, 51, 52, 53, 54, 55), la deuxième partie de boîtier (2) étant assemblée avec la première partie de boîtier (1), et
- une entrée (30) en fluide de refroidissement et une sortie (31) en fluide de refroidissement,
un canal de refroidissement étant ménagé dans la première partie de boîtier (1) ;
**caractérisé en ce que**
le canal de refroidissement est ménagé aussi dans la deuxième partie de boîtier (2) pour le fluide de refroidissement circulant de l'entrée (30) vers la sortie (31) de manière à refroidir tout ou partie des premiers composants électroniques et/ou tout ou partie des deuxièmes composants électroniques,
ce canal ayant sur la majorité de son parcours dans l'équipement entre l'entrée (30) et la sortie (31) en fluide de refroidissement, notamment sur la totalité de son parcours dans l'équipement, une section perpendiculaire à la direction d'écoulement du fluide qui est : exclusivement ménagée dans la première partie de boîtier (1), ou exclusivement ménagée dans la deuxième partie de boîtier (2).

2. Equipement selon la revendication 1, chacune de la première partie de boîtier et de la deuxième partie de boîtier présentant une paroi de fond (6, 20) et une paroi latérale (7, 21) s'étendant autour de la paroi de fond (6, 20).

3. Equipement selon la revendication 2, chaque paroi latérale (7, 21) s'étendant entre une extrémité de jonction avec la paroi de fond (6, 20) et une extrémité libre (10, 22), et la première partie de boîtier (1) et la deuxième partie de boîtier (2) étant assemblées par leur extrémité libre (10, 22).

4. Equipement selon la revendication 2 ou 3, le canal de refroidissement étant, dans la première partie du boîtier (1), ménagé uniquement dans la paroi latérale (7) et dans la paroi de fond (6), et/ou le canal de refroidissement étant, dans la deuxième partie de boîtier (2), ménagé uniquement dans la paroi latérale (21) et dans la paroi de fond (20).

5. Equipement selon l'une quelconque des revendications précédentes, l'entrée (30) et la sortie (31) en fluide de refroidissement étant montées sur la deuxième partie de boîtier (2).

6. Equipement selon la revendication 5, la deuxième partie de boîtier (2) comprenant un corps sur lequel est rapporté une plaque (26), l'entrée (30) et la sortie (31) en fluide de refroidissement étant montées sur cette plaque (26) et cette plaque définissant la portion du canal de refroidissement immédiatement adjacente à l'entrée (30) en fluide de refroidissement et la portion du canal de refroidissement immédiatement adjacente à la sortie (31) en fluide de refroidissement.

7. Equipement selon la revendication 6, la portion du canal de refroidissement immédiatement adjacente à l'entrée (30) en fluide de refroidissement définissant un embranchement entre deux branches pour le fluide entrant dans le canal de refroidissement et/ou la portion du canal de refroidissement immédiatement adjacente à la sortie (31) en fluide de refroidissement définissant une convergence entre deux branches vers la sortie du canal de refroidissement.

8. Equipement selon l'une des revendications 6 et 7, la deuxième partie de boîtier (2) comprenant une autre plaque (27) rapportée sur le corps, cette autre plaque (27) définissant une portion (39) du canal de refroidissement, notamment la portion du canal de refroidissement parcourue par le fluide de refroidissement dans la deuxième partie de boîtier (2) immédiatement après son parcours dans la première partie de boîtier (1).

9. Equipement selon l'une quelconque des revendications précédentes, la première partie de boîtier (1) recevant des cellules formant une unité de stockage d'énergie électrique, et la deuxième partie de boîtier recevant :
- un convertisseur statique (50, 51, 52), notamment un convertisseur de tension continu/continu, notamment un convertisseur de tension continu/continu 12V/ 48V, et
- un système de gestion (53) de l'unité de stockage d'énergie électrique.

10. Equipement selon l'une quelconque des revendications précédentes, la première partie de boîtier (1) et la deuxième partie de boîtier (2) formant le boîtier de l'équipement et encapsulant le ou les premiers composants électroniques et le ou les deuxièmes composants électroniques.

## Patentansprüche

1. Elektronische Vorrichtung für ein Kraftfahrzeug, die Folgendes beinhaltet:
- einen ersten Gehäuseteil (1), der dazu fähig ist, eine oder mehrere erste elektronische Komponenten aufzunehmen,
- einen zweiten Gehäuseteil (2), der dazu fähig ist, eine oder mehrere zweite elektronische Komponenten (50, 51, 52, 53, 54, 55) aufzunehmen, wobei der zweite Gehäuseteil (2) mit dem ersten Gehäuseteil (1) verbunden ist, und
- einen Eingang (30) für Kühlfluid und einen Ausgang (31) für Kühlfluid, wobei in dem ersten Gehäuseteil (1) ein Kühlkanal eingerichtet ist;
**dadurch gekennzeichnet, dass** für das Kühlfluid, das von dem Eingang (30) zu dem Ausgang (31) zirkuliert, der Kühlkanal auch in dem zweiten Gehäuseteil (2) eingerichtet ist, um alle oder einen Teil der ersten elektronischen Komponenten und/oder alle oder einen Teil der zweiten elektronischen Komponenten zu kühlen,
wobei dieser Kanal in seinem überwiegenden Verlauf in der Vorrichtung zwischen dem Eingang (30) und dem Ausgang (31) für Kühlfluid, insbesondere in seinem gesamten Verlauf in der Vorrichtung, einen zu der Strömungsrichtung des Fluids senkrechten Querschnitt aufweist, der: ausschließlich in dem ersten Gehäuseteil (1) eingerichtet ist oder ausschließlich in dem zweiten Gehäuseteil (2) eingerichtet ist.

2. Vorrichtung nach Anspruch 1, wobei jeder von dem ersten Gehäuseteil und dem zweiten Gehäuseteil eine Bodenwand (6, 20) und eine Seitenwand (7, 21), die sich um die Bodenwand (6, 20) erstreckt, aufweist.

3. Vorrichtung nach Anspruch 2, wobei sich jede Seitenwand (7, 21) zwischen einem Verbindungsende mit der Bodenwand (6, 20) und einem freien Ende (10, 22) erstreckt und der erste Gehäuseteil (1) und der zweite Gehäuseteil (2) durch ihr freies Ende (10, 22) verbunden sind.

4. Vorrichtung nach Anspruch 2 oder 3, wobei der Kühlkanal in dem ersten Gehäuseteil (1) nur in der Seitenwand (7) und in der Bodenwand (6) eingerichtet ist und/oder der Kühlkanal in dem zweiten Gehäuseteil (2) nur in der Seitenwand (21) und in der Bodenwand (20) eingerichtet ist.

5. Vorrichtung nach einem beliebigen der vorhergehenden Ansprüche, wobei der Eingang (30) und der Ausgang (31) für Kühlfluid an dem zweiten Gehäuseteil (2) montiert sind.

6. Vorrichtung nach Anspruch 5, wobei der zweite Gehäuseteil (2) einen Körper beinhaltet, an dem eine Platte (26) angebracht ist, wobei der Eingang (30) und der Ausgang (31) für Kühlfluid an dieser Platte (26) montiert sind und diese Platte den Abschnitt des Kühlkanals, der unmittelbar an den Eingang (30) für Kühlfluid angrenzt, und den Abschnitt des Kühlkanals, der unmittelbar an den Ausgang (31) für Kühlfluid angrenzt, definiert.

7. Vorrichtung nach Anspruch 6, wobei der Abschnitt des Kühlkanals, der unmittelbar an den Eingang (30) für Kühlfluid angrenzt, eine Verzweigung in zwei Zweige für das Fluid, das in den Kühlkanal eintritt, definiert und/oder der Abschnitt des Kühlkanals, der unmittelbar an den Ausgang (31) für Kühlfluid angrenzt, eine Zusammenführung von zwei Zweigen zu dem Ausgang des Kühlkanals hin definiert.

8. Vorrichtung nach einem der Ansprüche 6 und 7, wobei der zweite Gehäuseteil (2) eine weitere Platte (27), die an dem Körper angebracht ist, beinhaltet, wobei diese weitere Platte (27) einen Abschnitt (39) des Kühlkanals, insbesondere den Abschnitt des Kühlkanals, durch den das Kühlfluid in dem zweiten Gehäuseteil (2) direkt nach seinem Verlauf in dem ersten Gehäuseteil (1) verläuft, definiert.

9. Vorrichtung nach einem beliebigen der vorhergehenden Ansprüche, wobei der erste Gehäuseteil (1) Zellen aufnimmt, die eine Speichereinheit für elektrische Energie bilden, und der zweite Gehäuseteil Folgendes aufnimmt:
- einen statischen Umrichter (50, 51, 52), insbesondere einen Gleichspannungswandler, insbesondere einen 12V/48V-Gleichspannungswandler, und
- ein System zur Verwaltung (53) der Speichereinheit für elektrische Energie.

10. Vorrichtung nach einem beliebigen der vorhergehenden Ansprüche, wobei der erste Gehäuseteil (1) und der zweite Gehäuseteil (2) das Gehäuse der Vorrichtung bilden und die eine oder die mehreren ersten elektronischen Komponenten und die eine oder die mehreren zweiten elektronischen Komponenten einkapseln.

## Claims

1. Electronic equipment for a motor vehicle, comprising:
- a first housing part (1) capable of receiving one or more first electronic components,
- a second housing part (2) capable of receiving one or more second electronic components (50, 51, 52, 53, 54, 55), the second housing part (2) being assembled with the first housing part (1), and
- a cooling fluid inlet (30) and a cooling fluid outlet (31), a cooling channel being provided in the first housing part (1);
**characterized in that** the cooling channel is also provided in the second housing part (2) for the cooling fluid circulating from the inlet (30) to the outlet (31) so as to cool all or part of the first electronic components and/or all or part of the second electronic components,
this channel having, over most of its course in the equipment between the cooling fluid inlet (30) and the cooling fluid outlet (31), in particular over the whole of its course in the equipment, a section perpendicular to the flow direction of the fluid that is: exclusively provided in the first housing part (1), or exclusively provided in the second housing part (2).

2. Equipment according to Claim 1, each of the first housing part and of the second housing part having a bottom wall (6, 20) and a side wall (7, 21) extending around the bottom wall (6, 20).

3. Equipment according to Claim 2, each side wall (7, 21) extending between an end where it joins the bottom wall (6, 20) and a free end (10, 22), and the first housing part (1) and the second housing part (2) being assembled by their free end (10, 22).

4. Equipment according to Claim 2 or 3, the cooling channel being, in the first housing part (1), provided only in the side wall (7) and in the bottom wall (6), and/or the cooling channel being, in the second housing part (2), provided only in the side wall (21) and in the bottom wall (20).

5. Equipment according to any one of the preceding claims, the cooling fluid inlet (30) and the cooling fluid outlet (31) being mounted on the second housing part (2).

6. Equipment according to Claim 5, the second housing part (2) comprising a body to which a plate (26) is attached, the cooling fluid inlet (30) and the cooling fluid outlet (31) being mounted on this plate (26), and this plate defining the portion of the cooling channel immediately adjacent to the cooling fluid inlet (30) and the portion of the cooling channel immediately adjacent to the cooling fluid outlet (31).

7. Equipment according to Claim 6, the portion of the cooling channel immediately adjacent to the cooling fluid inlet (30) defining a branching between two branches for the fluid entering the cooling channel and/or the portion of the cooling channel immediately adjacent to the cooling fluid outlet (31) defining a convergence between two branches towards the outlet of the cooling channel.

8. Equipment according to either of Claims 6 and 7, the second housing part (2) comprising another plate (27) attached to the body, this other plate (27) defining a portion (39) of the cooling channel, in particular the portion of the cooling channel traversed by the cooling fluid in the second housing part (2) immediately after its flow in the first housing part (1).

9. Equipment according to any one of the preceding claims, the first housing part (1) receiving cells forming an electrical energy storage unit, and the second housing part receiving:
- a static converter (50, 51, 52), in particular a DC/DC voltage converter, in particular a 12V/48V DC/DC voltage converter, and
- a management system (53) for the electrical energy storage unit.

10. Equipment according to any one of the preceding claims, the first housing part (1) and the second housing part (2) forming the housing of the equipment and encapsulating the first electronic component(s) and the second electronic component(s).
